# EUROPEAN PATENT APPLICATION

(11) **EP 4 692 985 A1**
(43) Date of publication of application: **11.02.2026**
(21) Application number: 24781116.9
(22) Date of filing: 21.03.2024
(51) Int. Cl.: G06F 1/16, G06F 3/04847, G06F 3/0487, G06F 3/01

(54) **FOLDABLE ELECTRONIC DEVICE AND OPERATING METHOD OF SAME ELECTRONIC DEVICE**

(30) Priority: 28.03.2023 KR 20230040725; 31.05.2023 KR 20230070442
(71) Applicant: Samsung Electronics Co., Ltd., Suwon-si, Gyeonggi-do 16677 (KR)
(72) Inventor: WOO, Jonghoon, Suwon-si Gyeonggi-do 16677 (KR); SEO, Bowoong, Suwon-si Gyeonggi-do 16677 (KR); KANG, Hokyung, Suwon-si Gyeonggi-do 16677 (KR); KIM, Yongwoon, Suwon-si Gyeonggi-do 16677 (KR); PARK, Eunsoo, Suwon-si Gyeonggi-do 16677 (KR); AN, Jinwan, Suwon-si Gyeonggi-do 16677 (KR); HAN, Yonggil, Suwon-si Gyeonggi-do 16677 (KR)
(74) Representative: HGF
(86) International application number: PCT/KR2024/003546
(87) International publication number: WO 2024/205125

(57) **Abstract**

The present document relates to a foldable electronic device and an operating method of the electronic device. An electronic device, according to one embodiment, may comprise: a first housing and a second housing that are foldable against each other; a magnetic substance disposed in at least one of the first housing and the second housing; a memory; a Hall sensor that detects a magnetic force value of the magnetic substance that changes according to the folding of the first housing and the second housing, and outputs an interrupt signal on the basis of a set threshold; a motion sensor; and at least one processor electrically connected to the Hall sensor, the motion sensor, and the memory. According to one embodiment, the at least one processor may be configured to: identify folding angle information of the first housing and the second housing by means of the motion sensor according to identifying the interrupt signal; and change a first threshold of the Hall sensor on the basis of the folding angle information. Other embodiments are possible.

## Description

### [Technical Field]

The disclosure relates to a foldable electronic device and an operating method of the electronic device for preventing power consumption due to a malfunction in the electronic device.

### [Background Art]

Electronic devices are evolving in various forms for the convenience of users, offering various services, applications, or functions. As the variety of services, applications, and functions provided by electronic devices gradually increases, larger displays are required to provide more screen space.

In recent years, various types of electronic devices (e.g., foldable or flexible electronic devices) have been developed in which the shape of a housing may be transformed to accommodate a larger display. A foldable electronic device may have a housing of which a portion may be opened or closed, and external forces or user use may cause malfunctions of the electronic device by performing an unintended opening or closing operation.

### [Detailed Description of the Invention]

### [Technical Solution]

An electronic device may have an IC (hereinafter, a Hall IC) disposed in a housing and using the Hall effect utilizing changes in magnetic force, and the Hall IC may identify an opening and closing operation of the electronic device. The electronic device may be configured to prevent malfunction of drive transitions of a display due to a small magnetic difference in threshold values caused by an unintended opening or closing operation by an external force or user use. However, existing Hall IC operation methods simply use only a magnetic value along one axis of the Hall IC to identify whether a threshold value is exceeded, resulting in malfunctions due to various external influences, which may cause the electronic device to wake up and significantly increase current consumption and heat generation in the display and application processor (AP).

The disclosure is to provide a foldable electronic device and an operating method of the electronic device for preventing power consumption due to a malfunction in the electronic device.

An electronic device according to one embodiment of the disclosure may include a first housing and a second housing which are foldable with respect to each other, a magnetic substance disposed in at least one of the first housing and the second housing, memory, a Hall sensor configured to detect a magnetic force value of the magnetic substance, which varies according to folding of the first housing and the second housing, and output an interrupt signal, based on a set threshold value, a motion sensor, and at least one processor electrically connected to the Hall sensor, the motion sensor, and the memory.

According to an embodiment, the memory may store instructions which, when executed by the at least one processor, cause the electronic device to identify folding angle information of the first housing and the second housing by using the motion sensor according to identification of the interrupt signal.

According to an embodiment, the memory may store instructions which, when executed by the at least one processor, cause the electronic device to change the threshold value of the Hall sensor, based on the folding angle information.

According to an embodiment, an operating method of an electronic device may include an operation of identifying folding angle information of a first housing and a second housing of the electronic device by using a motion sensor according to identifying an interrupt signal output by a Hall sensor of the electronic device, based on a set threshold value.

According to an embodiment, the method may include an operation of changing the threshold value of the Hall sensor, based on the folding angle information.

According to an embodiment, a non-transitory computer-readable storage medium may store a program, wherein the program may include instructions which, when executed by at least one processor of an electronic device, cause the electronic device to perform an operation of identifying folding angle information of a first housing and a second housing of the electronic device by using a motion sensor of the electronic device according to identifying occurrences of an interrupt signal output by a Hall sensor of the electronic device and an operation of changing the threshold value of the Hall sensor, based on the folding angle information.

### [Brief Description of Drawings]

FIG. 1 is a block view illustrating an electronic device in a network environment according to various embodiments.
FIGS. 2A and 2B are views illustrating examples of a configuration of an electronic device according to an embodiment.
FIGS. 2C and 2D are views illustrating opening and closing of an electronic device according to an embodiment.
FIGS. 3A and 3B are views illustrating an example of a threshold value change of a Hall sensor in an electronic device according to an embodiment.
FIG. 4 is a view illustrating an example of an operating method in an electronic device according to an embodiment.
FIG. 5 is a view illustrating an example of an operating method in an electronic device according to an embodiment.
FIGS. 6A and 6B are views illustrating examples of an operating method in an electronic device according to an embodiment.
FIG. 7 is a view illustrating an example of an operating method in an electronic device according to an embodiment.
FIG. 8 is a view illustrating an example of an operating method in an electronic device according to an embodiment.
FIG. 9 is a view illustrating an effect of an operating method in an electronic device according to an embodiment.
FIG. 10 is a view illustrating an effect of an operating method in an electronic device according to an embodiment.

In connection with a description of the drawings, the same or like reference numerals may be used for the same or like elements.

### [Mode for Carrying out the Invention]

An electronic device according to various embodiments will be described with reference to attached drawings. The term "user" used in various embodiments may be referred to as a person who use an electronic device or a device (e.g., an artificial intelligence electronic device) that uses an electronic device.

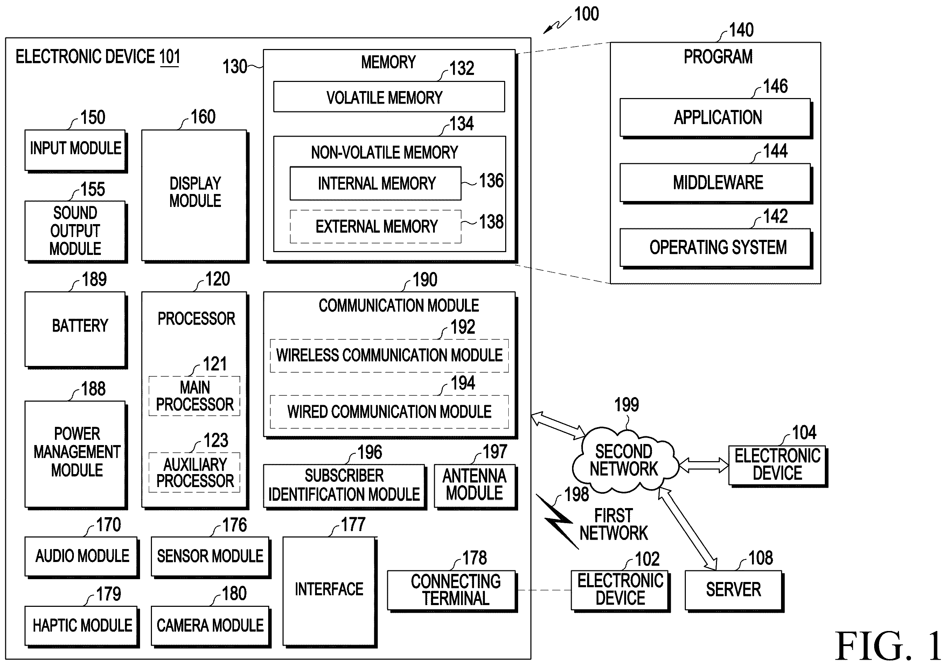

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing 1eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

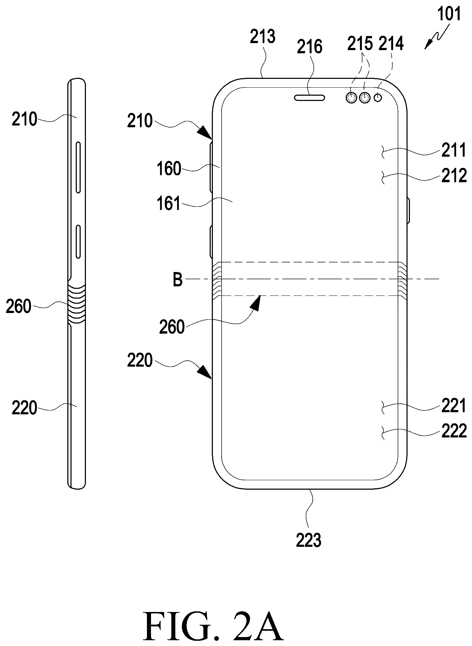

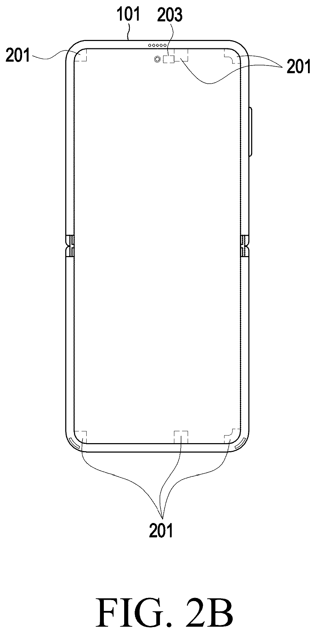

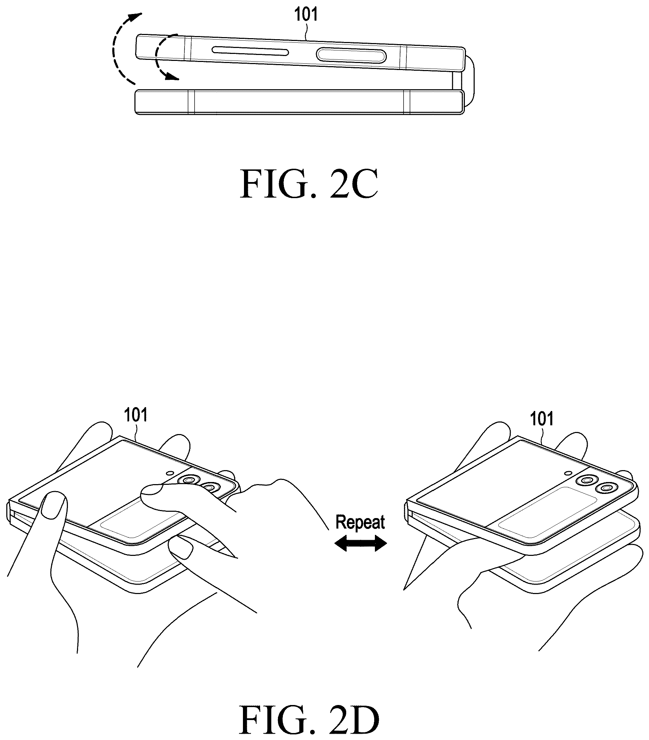

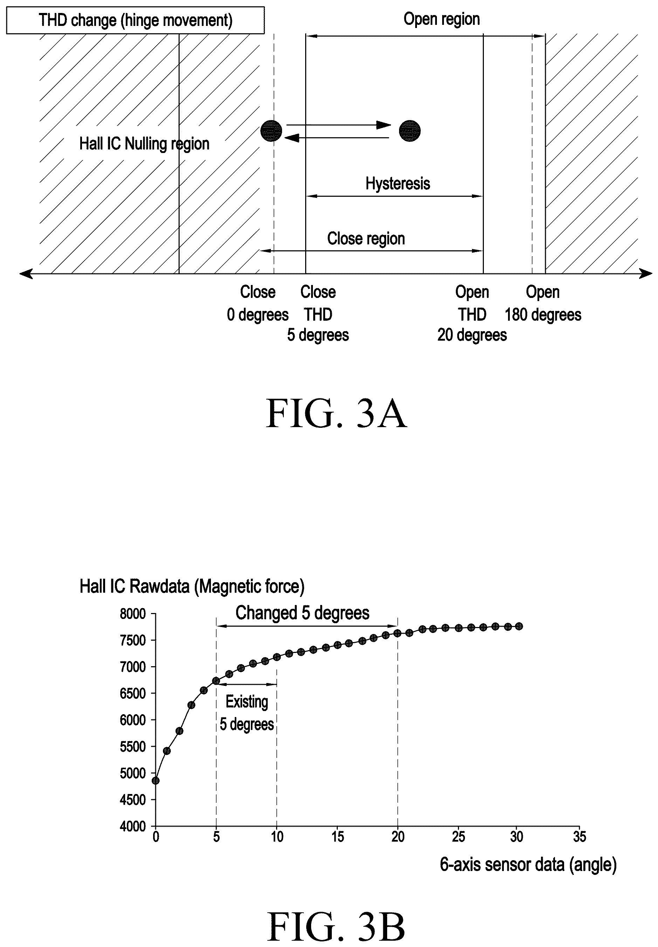

FIGS. 2A and 2B are views illustrating examples of a configuration of an electronic device according to an embodiment, FIGS. 2C and 2D are views illustrating opening and closing of an electronic device according to an embodiment, and FIGS. 3A and 3B are views illustrating an example of a threshold value change of a Hall sensor in an electronic device according to an embodiment.

Referring to FIGS. 1, 2A, 2B, 2C, and 2D, the electronic device 101 (e.g., the electronic device 101 in FIGS. 1, 2A, 2B, 2C, and 2D) according to an embodiment may include a housing including a first housing structure 210, a second housing structure 220, at least one processor 120, memory 130, a display module 160, and a sensor module 176 including multiple sensors. In addition, the electronic device may further include other components. The electronic device 101 may be configured to have the housing having a transformable shape (e.g., a foldable or flexible shape).

According to an embodiment, the first housing structure 210 and the second housing structure 220 may be disposed on opposite sides around a folding axis B (e.g., a folding axis in a horizontal direction) and may be rotatably coupled to each other around the folding axis B to be folded facing each other through a hinge structure 260. Without limitation thereto, according to another embodiment, the housing of the electronic device 101 may be configured by further including another housing structure other than the first housing structure 210 and the second housing structure 220 and may be configured to have a structure foldable in various shapes through multiple folding axes. According to another embodiment, the electronic device 101 may be configured so as to allow a portion of the housing to be folded in a direction (e.g., a y-axis perpendicular to B or a vertical direction) different from the folding axis B of FIG. 2A.

According to an embodiment, a camera 214, various sensors 215, and a speaker (e.g., a receiver) 216 included in the camera module (e.g., the camera module 180 in FIG. 1) may be disposed in the first housing structure 210. For another embodiment, the camera 214, the various sensors 215, and the speaker 216 may be additionally disposed in at least a partial area of the second housing structure 220 or replaced. According to another embodiment, at least a portion of the camera 214, the various sensors 215, and the speaker 216 may be disposed in at least a partial area of the first housing 210 and the remaining of the same may be disposed in at least a partial area of the second housing structure 220. The camera 214 may be exposed through an opening provided on one corner of a front surface (e.g., a first surface 211) of the first housing structure 210. The sensors 215 may include at least one of a proximity sensor, a light sensor, an iris recognition sensor, an ultrasonic sensor, or an indicator. By way of example, the sensors 215 may be exposed to the front surface of the electronic device 101 through an opening provided on one corner of the first housing structure 210 or may be disposed at a lower end of at least a partial area of the display 161. For example, the electronic device 101 may further include a camera (e.g., a rear camera) exposed through an opening provided on one corner of a second surface 212 of the first housing structure 210.

According to an embodiment, the electronic device 101 may include multiple opening and closing magnets 201 in each of the first housing structure 210 and the first housing structure 220, and a first sensor (e.g., a Hall sensor (Hall IC)) 203 configured to detect the generation of an interrupt signal based on a change in a magnetic force value of the opening and closing magnets 201 according to opening and closing. The electronic device 101 may include a second sensor (e.g., a motion sensor) configured to detect a motion and a folding angle of the electronic device according to opening and closing, and a third sensor (e.g., a grip sensor) configured to a grip state by a user's hand, and may further include various sensors in addition thereto. The second sensor is a motion sensor and has been described using at least one 6-axis sensor as an example, but may include various other sensors capable of detecting a motion and folding angle.

According to an embodiment, although not shown in the drawing, the electronic device 101 may include an ear jack hole, an external speaker module, a SIM card tray, an interface connector port, or at least one key button disposed through the first housing structure 210 and/or the housing structure 220.

According to an embodiment, an angle between the first housing structure 210 and the second housing structure 220 may have an angle and a distance therebetween according to an unfolded state (or open or flat state) (e.g., the unfolded state shown in FIGS. 2A and 2B), a folded state (or close state) (e.g., the folded state in FIG. 2C), or an intermediate state (or half folded state) of the electronic device 101. The description of the state may be replaced with a description of a mode. The intermediate state may indicate the half-folded state in which the first surface 211 of the first housing structure 210 and the second surface 221 of the second housing structure 220 are arranged to have a specified reference angle (e.g., 90 degrees or 80 degrees to 100 degrees) therebetween. The unfolded state may indicate a state in which the first face 211 of the first housing structure 210 and the first face 221 of the second housing structure 220 are being opened to have an angle within an angle range that exceeds a specified reference angle (e.g., 90 degrees to 180 degrees or 101 degrees to 180 degrees), or a fully open and unfolded state (e.g., a 180 degree angle). The folded state may indicate a state in which the first surface 211 of the first housing structure 210 and the first surface 221 of the second housing structure 220 are being closed to have an angle within an angle range that is less than a specified reference angle (e.g., less than 90 degrees or less than 80 degrees to 0 degrees to 5 degrees), or are fully closed and folded (e.g., 0 degrees to 5 degrees).

According to an embodiment, in case that the electronic device 101 performs an opening and closing operation by folding or unfolding (or opening) the first housing structure 210 and the second housing structure 220 relative to the hinge structure 260, by utilizing a magnetic force value that varies depending on a distance between the magnet (e.g., a magnetic substance) 201 and the first sensor (e.g., the Hall IC) 203, an open/close state may be determined by the first sensor based on a magnetic force (or strength of the magnetic force) caused by proximity of the magnet (e.g., the magnetic substance) 201 and the first sensor (e.g., the Hall sensor) 203. According to an embodiment, the first sensor (e.g., the Hall sensor) 203 may acquire the magnetic force of the magnetic substance in real time and, using the acquired magnetic force value, generate an interrupt signal when a value (folding angle) being greater than a threshold value (THD) in a predetermined range is identified. According to an embodiment, in case that the interrupt signal has been generated, the electronic device 101 may control waking up of an application processor (AP) according to the state of the electronic device 101 and perform an operation (e.g., display ON) suitable for the state of the electronic device 101.

According to an embodiment, the foldable electronic device 101 may be configured so that a hinge also has a holding force as magnets for fixing are disposed at both ends of a terminal for the folded state, but if the holding force of the hinge is exceeded due to external forces, shaking (e.g., running), deterioration of the holding force of the hinge over a period of use, or the like, the electronic device may not be completely closed and may become unfixable. In this case, since the magnetic force recognized by the first sensor 203 changes as a result of the opening, a flow of magnetic force may occur, as shown in FIG. 2C, causing the display to be switched to a driving state by the first sensor 203 regardless of the user's usage intentions, resulting in malfunction. As shown in FIG. 2D, the user may unconsciously perform repeated opening and closing operations of the foldable electronic device 101. In this case, the electronic device 101 may consume large amounts of current by driving unnecessary APs and displays when the user is not actually using the electronic device.

According to an embodiment, in case that a malfunction caused by an external force as shown in FIG. 2C and a malfunction caused by a hinge movement due to a repeated opening and closing operation as shown in FIG. 2D occurs, the electronic device may perform an operation to prevent the current consumption from increasing from a level of 10 mA in a sleep state (e.g., AP and LCD sleep state) to about 250 mA when the screen is turned on (e.g., AP and LCD wakeup).

According to an embodiment, the processor 120 of the electronic device 101 may identify the generation of the interrupt signal by the opening or closing of the housing of the electronic device 101 from the first sensor 203, based on the magnetic value detected by using the first sensor among multiple sensors. The processor 120 may identify whether the interrupt signal is generated in the sleep state and in case that the interrupt signal has not generated, may maintain the sleep state. Here, the sleep state may indicate a state where the AP and the display 161 are not driven (e.g., wakeup). The first sensor 203 may operate constantly in the sleep state without consuming additional current and generate an interrupt signal.

According to an embodiment, the processor 120 may acquire motion information of a portion of the housing by using the second sensor (e.g., the motion sensor) among the multiple sensors and identify folding angle information by using the motion information. Here, the second sensor may be multiple 6-axis sensors located at upper/bottom or left/right ends of the housing of the electronic device. The motion information may be acquired based on acceleration or gyro values detected by the second sensor, and may include information about whether the first housing structure 210 and the second housing structure 220 of the electronic device 101 are moving, and the amount of motion. The second sensor may operate constantly in the sleep state without consuming additional current and detect a motion and momentum.

According to an embodiment, the processor 120 may identify a malfunction and a normal operation of the electronic device 101, based on the motion information. According to an embodiment, the processor 120 may determine an operation state, based on a motion of the 6-axis sensor after the interrupt signal is generated. According to an embodiment, the processor 120 may identify the malfunction, for example, in case that a main sensor of the 6-axis sensors located in the first housing structure (e.g., an upper end or a left area) 210 of the electronic device 101 is in a stationary state, and a sub-sensor of the 6-axis sensors located in the second housing structure (e.g., a lower end or right area) 220 of the electronic device 101 is in a stationary state. According to an embodiment, the processor 120 may identify the normal operation, for example, in case that the main sensor located in the first housing structure 210 is in a motion state, and the sub-sensor located in the second housing structure 220 is in the stationary state. According to an embodiment, the processor 120 may identify the normal operation, for example, in case that the main sensor located in the first housing structure 210 is in the stationary state, and the sub-sensor located in the second housing structure 220 is in the motion state. According to an embodiment, the processor 120 may identify the normal operation in case that the main sensor located in the first housing structure 210 and the sub-sensor located in the second housing structure 220 is in the motion state and have different amounts of motion. According to an embodiment, the processor 120 may identify the malfunction in case that the main sensor located in the first housing structure 210 and the sub-sensor located in the second housing structure 220 is in the motion state and have an identical amount of motion.

According to an embodiment, the processor 120 may change a threshold value of the first sensor 203 from a first threshold value to a second threshold value, based on the identification of the malfunction. Here, the first threshold value may be configured using a magnetic force value for each of specified states (e.g., an open state, an open threshold state, a close threshold state, and a close state) of one axis (e.g., the X-axis), and may be changed to the second threshold value using the magnetic force value for each of the specified states (e.g., the open state, the open threshold state, the close threshold state, and the close state) of each of the three axes (e.g., the X, Y, and Z axes) when a malfunction is identified. According to an embodiment, the processor 120 may store, in the memory, data on the magnetic force of each of three axes collected through experiments using various types of external magnets, which may be used to identify a malfunction. Here, the malfunction of the electronic device 101 may cause the magnetic force recognized by the first sensor 203 to have different values in the x, y, and z axes depending on the location, strength, shape, and the like of a magnet. According to an embodiment, the processor 120 may utilize a difference between the magnetic force value acquired by the first sensor 203 and a fixed value caused by the folding of an upper end and lower end to identify the malfunction. According to an embodiment, the processor 120 may use one axis (e.g., the X-axis) during a normal condition, but may use three axes (e.g., the X, Y, and Z axes) when a change in magnetic force due to movement of the hinge is generated. As shown in FIG. 3A, according to an embodiment, the processor 120 may configure a nulling region in a magnetic force range that exceeds the magnetic force values in the open and close states by a predetermined amount to block out deviation of the magnetic force range that may occur in the electronic device 101. According to an embodiment, the processor 120 may compare the acquired magnetic force values to reference values for specified states of each of the three axes (e.g., the open state (e.g., 180 degrees), the open threshold (THD) state (e.g., 20 degrees), the close threshold (THD) state (e.g., 5 degrees), and the close state (e.g., 0 degrees)). Here, the close threshold (close THD) state may indicate a state where, when switching from opening to closing, a close threshold angle (e.g., 5 degrees) has been identified for recognizing the closing using a configured magnetic force value of the first sensor (e.g., the Hall sensor). The open threshold (open THD) state may indicate a state where, when switching from closing to opening, an open threshold angle (e.g., 10 degrees or 20 degrees) has been identified for recognizing the opening using a configured magnetic force value of the first sensor (e.g., the Hall sensor). The open state may indicate a state where a fully open angle (e.g., 180 degrees) is identified using a configured magnetic force value of the first sensor (e.g., the Hall sensor), and the close state may indicate a state where a fully close angle (e.g., 0 degrees) is identified using a configured magnetic force value of the first sensor (e.g., the Hall sensor).

Referring to FIGS. 3A and 3B, according to an embodiment, the processor 120 may change the open threshold angle (e.g., 10 degrees or 20 degrees) according to movement of the hinge. Here, the open threshold angle may indicate a threshold value of the first sensor for outputting the interrupt signal output by the first sensor (e.g., the Hall sensor). According to an embodiment, the processor 120 may change a threshold angle range (a hysteresis region representing a range between a close threshold angle (e.g., 5 degrees) and an open threshold angle) to prevent screen switching malfunction due to hinge movement. As the threshold value of the first sensor is changed from the first threshold value (e.g., the open threshold angle of 10 degrees) to the second threshold value (e.g., the open threshold angle of 20 degrees), the processor 120 may change an existing hysteresis region (e.g., the 5 degree to 10 degree region (5 degree interval)) to an expanded hysteresis region (e.g., the 5 degree to 20 degree region (15 degree interval)). According to an embodiment, the processor 120 may configure a folding angle of 0 to 20 degrees as a close region, and a folding angle of 5 to 180 degrees as an open region.

According to an embodiment, if not identified as a malfunction, the processor 120 may identify a normal operation and control the display module 160 to turn on the display 161.

According to an embodiment, when a malfunction is not identified using the first sensor and the second sensor and a normal operation is identified, the processor 120 may be configured to identify whether opening or closing of the electronic device is repeated for a short time period for each of additional specified modes (e.g., a hand mode and a bag mode) to identify the exact intent and situation, and to switch the display 1161 to a driving state.

According to an embodiment, the processor 120 may detect gripping by the user's hand by using the third sensor and identify whether it is a grip state. The processor 120 may be configured to switch from the sleep state to an AP-driven state as the interrupt signal is generated, and may identify whether it is in the grip state and the opening and closing repeats in the AP-driven state.

According to an embodiment, the processor 120 may, based on the grip state, identify the hand mode and perform an operation of identifying a malfunction caused by a hinge movement based on the folding angle and opening and closing repetitions in the hand mode. Here, the hand mode may be a mode in which the first threshold value (e.g., 10 degrees) of the previous first sensor at which an interrupt signal is output is changed to the second threshold value (e.g., 20 degrees) in order to prevent a malfunction caused by a hinge movement of the electronic device 101 by the user while holding the electronic device 101 with the user's hand, and when the opening and closing of the electronic device 101 is repeatedly performed, an operation of ignoring the interrupt signal for a predetermined time period is performed.

According to an embodiment, the processor 120 may, based on a non-grip state, identify the bag mode and identify a malfunction caused by a hinge movement based on the folding angle and opening and closing repetitions in the bag mode. Here, the bag mode may be a mode in which the threshold value of the first sensor 203 is changed to the second threshold value (e.g., 20 degrees) to prevent an external force (e.g., running, climbing stairs, riding an amusement ride) that exceeds the fixing force of the hinge of the electronic device 101 from occurring while the electronic device 101 is in a user's bag or pocket, and when the opening and closing of the electronic device 101 is repeatedly performed, the operation of ignoring the interrupt signal for a predetermined time period is performed.

According to an embodiment, the processor 120 may compare a folding angle (e.g., a set angle configured by including angles measured over a specified time period (e.g., 1 or 1.5 seconds)) acquired using the second sensor in the hand mode to a first reference angle (e.g., 20 degrees) to identify a malfunction due to hinge movement. When it is identified that the folding angle is less than or equal to the first threshold angle (e.g., 20 degrees), the processor 120 may identify a malfunction caused by a hinge movement, and may change the threshold value of the first sensor (e.g., the Hall sensor) to the second threshold value (e.g., 20 degrees) to expand the threshold angle range (e.g., the hysteresis region) (e.g., from a 5 degree interval to a 15 degree interval) to prevent malfunction caused by a hinge movement. Here, the first reference angle (e.g., 20 degrees) may be specified as another angle according to a model or empirical judgment of the electronic device.

According to an embodiment, when it is identified that the folding angle exceeds the first reference angle (e.g., 20 degrees), the processor 120 may compare the folding angle to the second reference angle (e.g., 90 degrees) to identify the opening and closing repetition in the hand mode. In the hand mode, there are many malfunctions caused by the user's repeated opening and closing operations, thus it is possible to separately identify a timeout time based on the second reference angle (e.g., 90 degrees). In this case, the second reference angle may additionally be specified as a different angle (e.g., 80 degrees or 70 degrees) depending on the model of the electronic device, the user's experience, usage environment, or usage habits. According to an embodiment, when the folding angle does not exceed the second reference angle (e.g., 90 degrees), the processor 120 may identify whether an interrupt signal is generated during a first timeout period (e.g., 1 second). When the interrupt signal has been generated, the processor 120 may identify that it is the opening and closing repetition, and when the interrupt signal is not generated, may identify the normal operation. According to an embodiment, when the folding angle exceeds the second reference angle (e.g., 90 degrees), the processor 120 may identify whether an interrupt signal is generated during a second timeout period (e.g., 1.5 second). When the interrupt signal has been generated, the processor may identify that it is the opening and closing repetition, and when the interrupt signal is not generated, may identify the normal operation.

According to an embodiment, when the opening and closing repetition is identified, the processor 120 may increase a count and when the increased count is greater than or equal to a reference value, may ignore the interrupt signal for a predetermined time. According to an embodiment, when the increased count is less than a reference value, the processor 120 may determine an operation state of the electronic device 101 as the normal operation.

According to an embodiment, the processor 120 may compare the folding angle acquired using the second sensor in the bag mode to the first reference angle (e.g., 20 degrees). Here, the first reference angle (e.g., 20 degrees) may be specified as another angle according to a model or empirical judgment of the electronic device. According to an embodiment, based on the folding angle being less than or equal to the first threshold angle (e.g., 20 degrees), the processor 120 may identify a malfunction caused by a hinge movement, and may change the threshold value of the first sensor to the second threshold value (e.g., 20 degrees) to expand the threshold angle range (e.g., the hysteresis region) (e.g., from a 5 degree range to a 15 degree range) to prevent malfunction caused by a hinge movement. According to an embodiment, the processor 120 may identify whether the interrupt signal has been generated during the timeout time (e.g., 1 second), in case that the interrupt signal has been generated, identify the opening and closing repetition, and in case that the interrupt signal has not been generated, identify the operation state of the electronic device 101 as the normal operation.

According to an embodiment, the processor 120 may increase the count according to identifying the opening and closing repetition, and when the increased count is greater than or equal to a threshold value, ignore the interrupt signal for a predetermined time period, and when the increased count is less than the threshold value, identify the operation state of the electronic device 101 as the normal operation.

According to an embodiment, when ignoring the interrupt signal, the processor 120 may control the display 161 to turn on only a portion of the display to display a notification message (e.g., "Folding repetition detected" or "Folding repetition detected, only part of the screen has been turned on to conserve battery time. If you want to view the full screen, please touch below.") instead of a debounce time that forces the display 161 off.

According to an embodiment, when the interrupt signal has been generated, the processor 120 may perform an operation corresponding to each malfunction situation by using sensing data (e.g., raw data) of the second sensor and the third sensor, an operation of changing the first threshold value and/or the second threshold value, finally identifying the state of the first sensor (e.g., the Hall sensor), and driving or not driving the display, and then restore the first threshold value and/or the second threshold value.

The electronic device 101 according to an embodiment may realize a software module (e.g., the program 140 in FIG. 1) for preventing current consumption due to the malfunction. The memory 130 of the electronic device 101 may store commands (e.g., instructions) for realizing the software module. The at least one processor 120 may execute the instructions stored in the memory 130 to realize the software module and control hardware (e.g., the sensor module 176, the power management module 188, or the communication module 190 in FIG. 1) related to functions of the software module. According to an embodiment, the software module of the electronic device 101 may be configured by including a kernel (or HAL), a framework (e.g., the middleware 144 in FIG. 1), and an application (e.g., the application 146 in FIG. 1). At least a portion of the software module may be preloaded on the electronic device 101 or downloadable from a server (e.g., the server 108).

In the embodiment above, the main components of the electronic device have been explained through the electronic device 101 in FIGS. 1 and 2A to 2D. However, in various embodiments, not all of the components illustrated through FIGS. 1 and 2A to 2D are essential components, and the electronic device 101 may be implemented with more components than the illustrated components, or the electronic device 101 may be implemented with fewer components. Furthermore, the positions of the main components of the electronic device 101 described through the FIGS. 1 and 2A to 2D may vary according to various embodiments.

According to one embodiment, a foldable electronic device (e.g., the electronic device 101 in FIGS. 1 and 2A to 2D) may include a first housing and a second housing that are foldable with respect to each other, a magnetic substance disposed in at least one of the first housing and the second housing, memory (e.g., the memory 130 in FIG. 1), a Hall sensor (e.g., the Hall sensor 203 in FIGS. 2A and 2B) configured to detect a magnetic force value of the magnetic substance, which changes according to folding of the first housing and the second housing, and output an interrupt signal based on a set threshold value, a motion sensor, and at least one processor (e.g., the processor 120 in FIG. 1) electrically connected to the Hall sensor, the motion sensor, and the memory.

According to an embodiment, the memory may store instructions, when executed by the at least one processor, causing the electronic device to identify folding angle information of the first housing and the second housing by using the motion sensor according to identification of the interrupt signal.

According to an embodiment, the memory may store instructions, when executed by the at least one processor, causing the electronic device to change the threshold value of the Hall sensor, based on the folding angle information.

According to an embodiment, the memory may store instructions, when executed by the at least one processor, causing the electronic device to identify a malfunction of the electronic device, based on motion information acquired using the motion sensor and change the threshold value of the Hall sensor from a first threshold value to a second threshold value.

According to an embodiment, the motion information may include whether each of the first housing structure and the second housing structure moves and the amount of motion.

According to an embodiment, the motion sensor may include at least one 6-axis sensor.

According to an embodiment, the first threshold value may be an open threshold angle set using a magnetic force value of one axis of the motion sensor, and the second threshold value may be an open threshold angle set using a magnetic force value of each of the three axes of the motion sensor.

According to an embodiment, the memory may store instructions, when executed by the at least one processor, causing the electronic device to identify a bag mode or a hand mode of the electronic device by using a third sensor of the multiple sensors, acquire a folding angle configured by the opening and closing of the electronic device by using a second sensor, identify a malfunction caused by a hinge movement and change a second threshold value of the Hall sensor, based on the folding angle being less than or equal to a first reference angle.

According to an embodiment, the memory may store instructions, when executed by the at least one processor, causing the electronic device to, in the bag mode, ignore the interrupt signal for a specified time period based on identifying the folding angle being greater than the first reference angle and the opening and closing repetition of the first housing and the second housing, in the bag mode, identify a normal operation and switch the display of the electronic device to a driving state, based on the folding angle being greater than the first reference angle and identifying no opening and closing repetition.

According to an embodiment, the memory may store instructions, when executed by the at least one processor, causing the electronic device to, in case that the interrupt signal has been generated a specified number of times or more in a specified time period, identify the opening and closing repetition.

According to an embodiment, the memory may store instructions, when executed by the at least one processor, causing the electronic device to, in the hand mode, ignore the interrupt signal for a specified time period based on identifying the folding angle being greater than the first reference angle and the opening and closing repetition of the first housing and the second housing, in the hand mode, identify a normal operation and switch the display of the electronic device to a driving state, based on identifying the folding angle being greater than the first reference angle and the absence of the opening and closing repetition,.

According to an embodiment, the memory may store instructions, when executed by the at least one processor, causing the electronic device to, in the hand mode, identify the opening and closing repetition in case that the folding angle being greater than the second reference angle and the interrupt signal is generated a specified number of times or more during a specified first time period, and, in the hand mode, identify the opening and closing repetition in case that the folding angle is less than or equal to the second reference angle and the interrupt signal is generated a specified number of times or more during a specified second time period.

According to an embodiment, the memory may store instructions, when executed by the at least one processor, causing the electronic device to change the second threshold value to a second folding angle greater than a specified first folding angle when changing the second threshold value of the first sensor.

According to an embodiment, the memory may store instructions, when executed by the at least one processor, causing the electronic device to activate a partial area and deactivate a remaining area of the display of the electronic device, based on identifying the folding angle being greater than the first reference angle and the opening and closing repetition of the first housing and the second housing and control the display to display a notification message on a partial area of the display.

According to an embodiment, the memory may store instructions, when executed by the at least one processor, causing the electronic device to perform operations of driving the display, and then restore the changed threshold value of the Hall sensor.

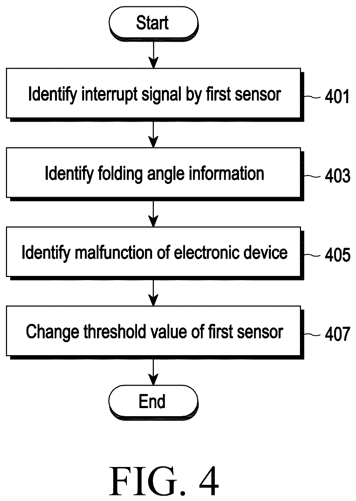

FIG. 4 is a view illustrating an example of an operating method in an electronic device according to an embodiment.

Referring to FIG. 4, in operation 401, the electronic device (e.g., the electronic device 101 in FIGS. 1 and 2A to 2D) according to an embodiment may identify an interrupt signal generated from a first sensor, based on a magnetic force value detected using the first sensor among multiple sensors. Here, the first sensor may correspond to a Hall sensor (Hall IC).

In operation 403, the electronic device may identify folding angle information of a first housing and a second housing by using a second sensor among the multiple sensors according to the identification of the interrupt signal. Here, the second sensor may correspond to a motion sensor. In the disclosure, the second sensor is a motion sensor and has been described using at least one 6-axis sensor as an example, but may include various other sensors capable of detecting a motion and folding angle. Here, the folding angle information may be information (including a folding angle configured as a set angle by including an angle identified based on 6-axis sensor data corresponding to a magnetic force and/or angles measured during a specified time period (e.g., 1 second or 1.5 seconds) in an opening and closing repetition situation (e.g., a malfunction situation due to hinge movement)) related to an angle between the first housing and the second housing according to motion of the first housing and/or the second housing rotating around a folding axis (e.g., B in FIG. 2A) of the electronic device.

In operation 405, the electronic device may identify, based on the folding angle information, a malfunction (e.g., a malfunction caused by an external magnetic force and/or a malfunction caused by a hinge movement). In operation 407, the electronic device may change a threshold value of the first sensor according to the identification of the malfunction.

According to an embodiment, the electronic device may identify, based on the identified folding angle information, a malfunction caused by an external magnetic force when, for example, identifying a stationary state with no movement of the 6-axis sensor, or identifying that sensors at different positions have an identical amount of motion (raw data). The electronic device may change, based on the identification of the malfunction caused by an external magnetic force, a threshold value of the first sensor from a specified threshold value THD #0 to a first threshold value THD #1. Here, the specified threshold value THD #0 is an initially configured process threshold, which may be configured using a magnetic force value for each specified state (e.g., an open state, an open threshold state, a close threshold state, and a close state) of one (e.g., the x-axis) of the X, Y, or Z axes. The first threshold value THD #1 may be configured using a nulling region of the Hall sensor configured to ignore magnetic forces beyond a close-open region due to external magnetic forces, and a magnetic force value for each of the specified states (e.g., the open state, the open threshold state, the close threshold state, and the close state) of each of the three axes (e.g., the x, y, and z axes).

According to an embodiment, in case of identifying the malfunction caused by a hinge movement based on the identified folding angle information, the electronic device may change a threshold value of the first sensor to the specified threshold value THD #0 or from the first threshold value THD #1 to a second threshold value THD #2. Here, the second threshold value THD #2 may be configured using a nulling region of the Hall sensor configured to ignore magnetic forces beyond a close-open region due to external magnetic forces, magnetic force values for each of the three axes (e.g., the x, y, and z axes), and an open angle range (hysteresis region) condition.

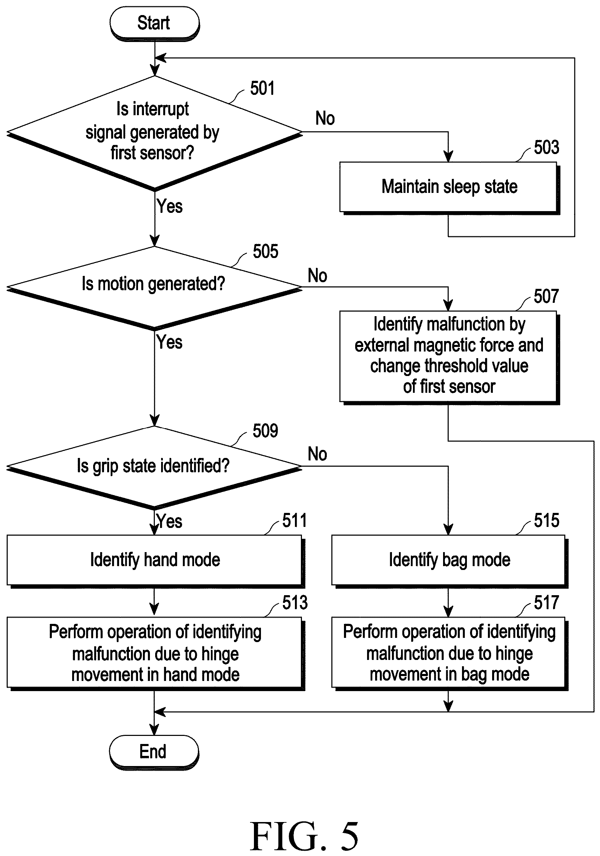

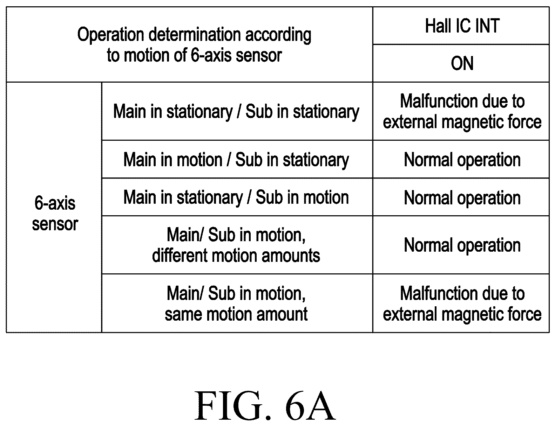

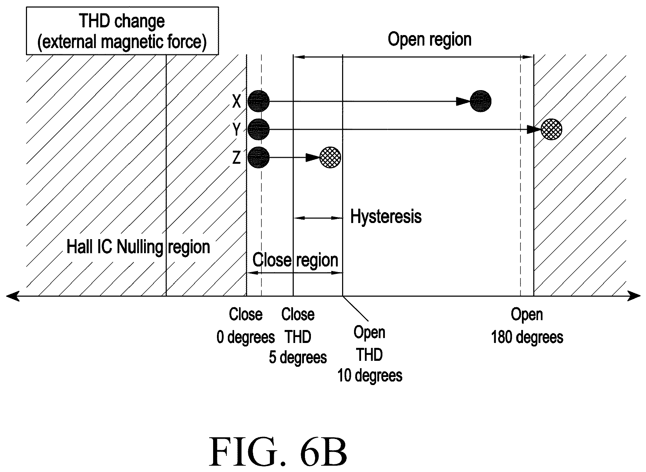

FIG. 5 is a view illustrating an example of an operating method in an electronic device according to an embodiment and FIGS. 6A and 6B are views illustrating examples of an operating method in an electronic device according to an embodiment.

Referring to FIGS. 5, 6A, and 6B, in operation 501, the electronic device (e.g., the electronic device 101 in FIGS. 1 and 2A to 2D) according to an embodiment may identify whether an interrupt signal by the opening or closing a housing of the electronic device has been generated from a first sensor, based on a magnetic force value detected using the first sensor among multiple sensors. Here, the first sensor may correspond to a Hall sensor (Hall IC). As a result of the identification, in case that no interrupt signal has been generated, the electronic device may remain in a sleep state in operation 503. Here, the sleep state may indicate a state where an AP and a display are not driven (e.g., wakeup). The first sensor may operate constantly in the sleep state without consuming additional current and generate an interrupt signal. As a result of the identification in operation 501, in case that an interrupt signal has been generated from, the electronic device may perform operation 505.

In operation 505, the electronic device according to an embodiment may identify whether a portion (a first housing and/or a second housing) of the housing moves, by using a second sensor (e.g., a motion sensor) among the multiple sensors. Here, the second sensor may be multiple 6-axis sensors located at upper/bottom or left/right ends of the housing of the electronic device. The electronic device may acquire motion information including whether each of a first housing structure and a second housing structure of the electronic device moves and a motion amount thereof by the second sensor and may acquire folding angle information based on magnetic force values and the motion information. The second sensor may operate constantly in the sleep state without consuming additional current and detect a motion and momentum. The electronic device according to an embodiment may identify whether there is a malfunction of the electronic device, based on the folding angle information.

As a result of the identification in operation 505, in case that the movement has been generated, the electronic device may perform operation 509 and in case that the movement is not generated, the electronic device may perform operation 507. According to an embodiment, the electronic device may determine an operation based on the movement of the 6-axis sensor, as shown in FIG. 6A, after the interrupt signal is generated. For example, the electronic device may identify the malfunction caused by an external magnetic force in case that, for example, a main sensor of the 6-axis sensors located in the first housing structure (e.g., an upper end or a left area) of the electronic device is in a stationary state, and a sub-sensor of the 6-axis sensors located in the second housing structure (e.g., a lower end or a right area) of the electronic device is in a stationary state. For example, the electronic device may identify a normal operation in case that, for example, the main sensor located in the first housing structure (e.g., the upper end or the left area) is in a motion state, and the sub-sensor located in the second housing structure (e.g., the lower end or the right area) of the electronic device is in a stationary state. For example, the electronic device may identify the normal operation in case that, for example, the main sensor located in the first housing structure (e.g., the upper end or the left area) is in the stationary state, and the sub-sensor located in the second housing structure (e.g., the lower end or the right area) of the electronic device is in the motion state. For example, the electronic device may identify the normal operation in case that, for example, the main sensor located in the first housing structure (e.g., the upper end or the left area) and the sub-sensor located in the second housing structure (e.g., the lower end or the right area) of the electronic device are in the motion state and have different motion amounts. For example, the electronic device may identify the malfunction caused by an external magnetic force in case that, for example, the main sensor located in the first housing structure (e.g., the upper end or the left area) and the sub-sensor located in the second housing structure (e.g., the lower end or the right area) of the electronic device are in the motion state and have an identical motion amount.

In operation 507 (operation 505-No), the electronic device may identify the malfunction caused by an external magnetic force and change the threshold value of the first sensor. The electronic device may change a threshold value of the first sensor from a reference threshold value THD #0 to a first threshold value THD #1. Here, the reference threshold value THD #0 may be configured using a magnetic force value for each specified state (e.g., an open state, an open threshold state, a close threshold state, and a close state) of one axis (e.g., the x-axis). The first threshold value THD #1 may be configured using a magnetic force value for each of the specified states (e.g., the open state, the open threshold state, the close threshold state, and the close state) of each of the three axes (e.g., the x, y, and z axes) in case that the malfunction of the electronic device caused by the external magnetic force as shown in FIG. 6B. According to an embodiment, the electronic device may store, in memory, data on the magnetic force of each of three axes collected through experiments using various types of external magnets, which may be used to identify the malfunction caused by the external magnetic force. Here, the malfunction caused by the external magnetic force of the electronic device 101 may cause the magnetic force recognized by the first sensor (Hall IC) to have different values in the x, y, and z axes depending on the location, strength, shape, and the like of a magnet. As shown in FIG. 6B, when identifying the malfunction caused by the external magnetic force, the electronic device may utilize a difference between the magnetic force value acquired by the first sensor and a fixed value caused by the folding of an upper end and lower end. The electronic device may use one axis (e.g., the X-axis) during a normal condition, but may use three axes (e.g., the X, Y, and Z axes) when a change in external magnetic force is generated. The electronic device may configure a nulling region for magnetic force range that exceeds the magnetic force values in the open and close states by a predetermined amount to block out deviation of the magnetic force range that may occur in the electronic device. According to an embodiment, the electronic device may compare the acquired external magnetic force values to reference values for specified states of each of the three axes (e.g., the open state, the open threshold (open THD) state, the close threshold (close THD) state, and the close state). The electronic device may identify the malfunction in case that the acquired external magnetic force value is greater than a reference value of the open state when comparing only the x-axis, and prevent the malfunction in case that the acquired external magnetic force values of the y-axis and z-axis are less than or equal to a reference value of the open threshold state of the y-axis and exceed a threshold value of the open state of the z-axis, respectively. The electronic device may identify the malfunction in case that each of the acquired external magnetic force values of the x-axis and the z-axis are greater than or equal to a reference value of the open threshold state and prevent the malfunction in case that the acquired external magnetic force of the y-axis exceeds a reference value of the open state of the y-axis. The electronic device may identify the malfunction in case that the acquired external magnetic force value is greater than a reference value of the open threshold state when comparing only the x-axis, and prevent the malfunction in case that the acquired external magnetic force values of the y-axis and z-axis exceed a reference value of the open state of the y-axis and are less than a threshold value of the open threshold state of the z-axis, respectively.

As a result of the identification in operation 505, in case that the movement has been generated, the electronic device may identify normal operation without identifying a malfunction caused by an external magnetic force, or may perform operations of identifying a malfunction caused by a hinge movement, such as operations after 509, in which it is additionally identified whether the electronic device is repeatedly opened and closed for a short time period for each specified mode (e.g., a hand mode and a bag mode). The electronic device may switch the display to a driving (ON) state by identifying the correct intent and situation through identification of the malfunction by the hinge movement.

In operation 509, the electronic device according to an embodiment may detect gripping by the user's hand by using the third sensor and identify whether it is a grip state. As a result of the identification, in case that it is the grip state, the electronic device may perform operation 511 and when it is not the grip state, the electronic device may perform operation 515.

In operation 511, the electronic device may identify the hand mode, based on the grip state. In operation 513, the electronic device may perform an operation of identifying a malfunction caused by a hinge movement based on the folding angle and opening and closing repetitions in the hand mode. Here, the hand mode may be a mode of changing a second threshold value (e.g., a folding angle at which an interrupt signal is generated) of the first sensor (e.g., from 5 degrees to 20 degrees) to prevent a malfunction caused by a hinge movement of the electronic device by the user while holding the electronic device with the user's hand, and performing an operation of ignoring the interrupt signal for a predetermined time period when the opening and closing of the electronic device is repeatedly performed.

In operation 515, the electronic device may identify the bag mode, based on a non-grip state. In operation 517, the electronic device may perform an operation of identifying a malfunction caused by a hinge movement based on the folding angle and opening and closing repetitions in the bag mode. Here, the bag mode may be a mode in which the threshold value of the first sensor is changed to the second threshold value (e.g., 20 degrees) to prevent an external force (e.g., running, climbing stairs, riding an amusement ride) that exceeds the fixing force of the hinge of the electronic device from occurring while the electronic device is in a user's bag or pocket, and when the opening and closing of the electronic device is repeatedly performed, the operation of ignoring the interrupt signal for a predetermined time period is performed.

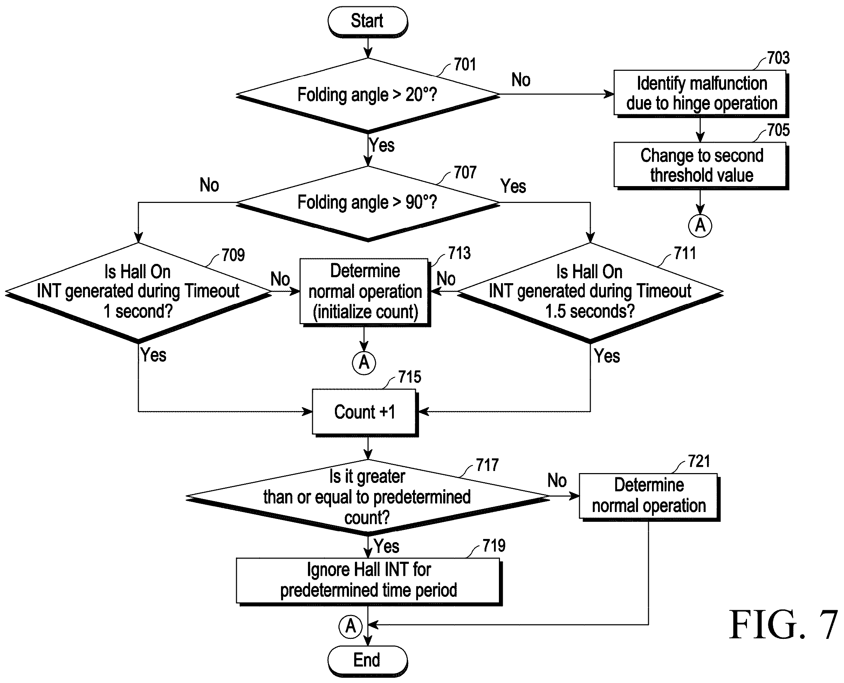

FIG. 7 is a view illustrating an example of an operating method in a hand mode in an electronic device according to an embodiment.

According to an embodiment, the electronic device (e.g., the electronic device 101 in FIGS. 1 and 2A to 2D) may perform an operation for identifying a malfunction caused by a hinge movement in the hand mode as shown in operations 511 and 513 in FIG. 5.

Referring to FIG. 7, in operation 701, the electronic device according to an embodiment may identify whether a folding angle acquired by using the second sensor in the hand mode is equal to or less than a first reference angle (e.g., 20 degrees). As a result of the identification, in case that the folding angle is less than or equal to the first reference angle (e.g., 20 degrees), the electronic device may perform operation 703, and in case that the folding angle exceeds the first reference angle (e.g., 20 degrees), the electronic device may perform operation 707. Here, the first reference angle (e.g., 20 degrees) may be specified as another angle according to a model or empirical judgment of the electronic device.

In operation 703, the electronic device may identify a malfunction caused by a hinge movement, based on the folding angle being equal to or less than the first reference angle (e.g., 20 degrees). In operation 705, the electronic device may change a threshold value of the first sensor to a second threshold value so as to prevent the malfunction caused by the hinge movement. For example, the electronic device may change the threshold value (e.g., an open threshold angle of 10 degrees) of the first sensor to the second threshold value (e.g., an open threshold angle of 20 degrees).

In operation 707, the electronic device may identify whether the folding angle exceeds a second reference angle (e.g., 90 degrees), based on the folding angle being greater than the first reference angle (e.g., 20 degrees). In the hand mode, in the hand mode, there are many malfunctions caused by the user's repeated opening and closing operations, thus it is possible to separately identify a timeout time based on the second reference angle (e.g., 90 degrees). In this case, the second reference angle may additionally be specified as a different angle (e.g., 80 degrees or 70 degrees) depending on the model of the electronic device, the user's experience, usage environment, or usage habits.

As a result of the identification in operation 707, in case that the folding angle does not exceed the second reference angle (e.g., 90 degrees), the electronic device may identify, in operation 709, whether an interrupt signal is generated during a first timeout period (e.g., 1 second). As a result of the identification, in case that the interrupt signal has been generated, the electronic device may perform operation 715 according to identifying the opening and closing repetition, and in case that no interrupt signal has been generated, the electronic device may identify a normal operation in operation 713.

As a result of the identification in operation 707, in case that the folding angle exceeds the second reference angle (e.g., 90 degrees), the electronic device may identify, in operation 711, whether an interrupt signal is generated during a second timeout period (e.g., 1.5 second). As a result of the identification, in case that the interrupt signal has been generated, the electronic device may perform operation 715 according to identifying the opening and closing repetition, and in case that no interrupt signal has been generated, the electronic device may identify a normal operation in operation 713.

In operation 715, the electronic device may increase the count by 1 as the opening and closing repetition is identified, and in operation 717, the electronic device may determine whether the increased count is greater than or equal to a threshold value.

As a result of the identification in operation 717, in case that the increased count is greater than or equal to the threshold value, the electronic device may ignore the interrupt signal during a predetermined time period in operation 719.

As the result of the identification in operation 717, in case that the increased count is less than the threshold value, the electronic device may identify the normal operation in operation 721.

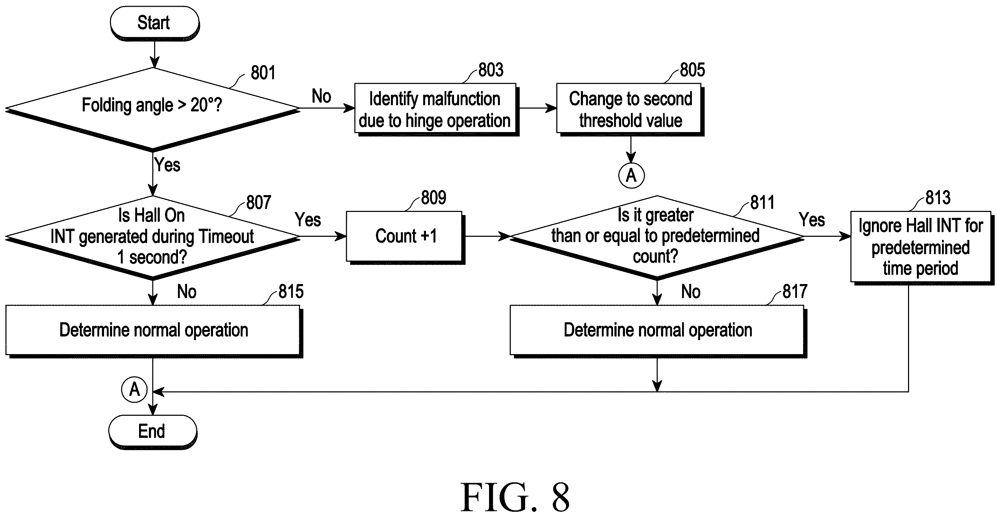

FIG. 8 is a view illustrating an example of an operating method in a bag mode in an electronic device according to an embodiment.

According to an embodiment, the electronic device (e.g., the electronic device 101 in FIGS. 1 and 2A to 2D) may perform an operation for identifying a malfunction caused by a hinge movement in the bag mode as shown in operations 515 and 517 in FIG. 5.

Referring to FIG. 8, in operation 801, the electronic device according to an embodiment may identify whether a folding angle acquired by using the second sensor in the hand mode is equal to or less than the first reference angle (e.g., 20 degrees). As a result of the identification, in case that the folding angle is less than or equal to the first reference angle (e.g., 20 degrees), the electronic device may perform operation 803, and in case that the folding angle exceeds the first reference angle (e.g., 20 degrees), the electronic device may perform operation 807. Here, the first reference angle (e.g., 20 degrees) may be specified as another angle according to a model or empirical judgment of the electronic device.

In operation 803, the electronic device may identify a malfunction caused by a hinge movement, based on the folding angle being equal to or less than a reference folding angle (e.g., 20 degrees). In operation 805, the electronic device may change a threshold value of the first sensor to a second threshold value so as to prevent the malfunction caused by the hinge movement. For example, the electronic device may change the angle specified as the second threshold from 10 degrees open to 20 degrees open.

In operation 807, the electronic device may identify whether the interrupt signal is generated during the timeout time period (e.g., 1 second). As a result of the identification, in case that the interrupt signal has been generated, the electronic device may perform operation 811 according to identifying the opening and closing repetition, and in case that no interrupt signal has been generated, the electronic device may identify a normal operation in operation 809.

In operation 811, the electronic device may increase the count by 1 as the opening and closing repetition is identified, and in operation 813, the electronic device may determine whether the increased count is greater than or equal to a threshold value.

As a result of the identification in operation 813, in case that the increased count is greater than or equal to the threshold value, the electronic device may ignore the interrupt signal during a predetermined time period in operation 815.

As the result of the identification in operation 813, in case that the increased count is less than the threshold value, the electronic device may identify the normal operation in operation 817.

According to an embodiment, when the interrupt signal has been generated, the electronic device may perform an operation corresponding to each malfunction situation by using sensing data of the second sensor (e.g., a motion sensor) and the third sensor (e.g., a grip sensor), an operation of changing the first threshold value and/or the second threshold value, finally identifying the state of the first sensor (e.g., the Hall sensor), and driving or not driving the display, then restore the first threshold value and/or the second threshold value, and end the operations described in FIGS. 4, 6, 7, and 8.

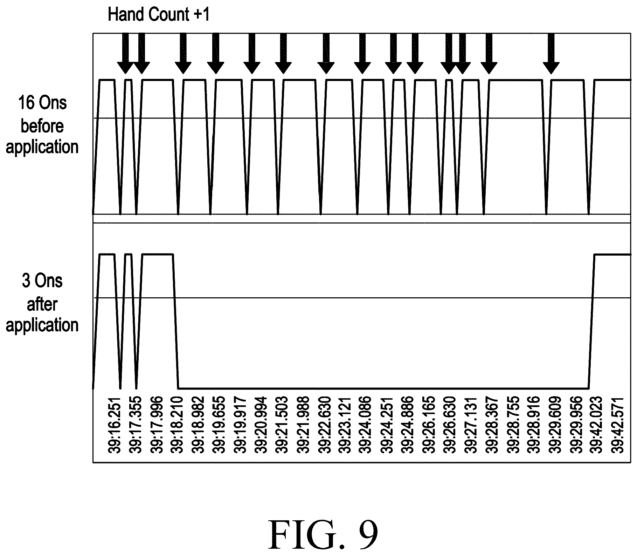

FIG. 9 is a view illustrating an effect of an operating method in an electronic device according to an embodiment.

Referring to FIG. 9, the electronic device (e.g., the electronic device 101 in FIGS. 1 and 2A to 2D) according to an embodiment may reduce the current consumption of the electronic device by preventing, for example, 13 malfunctions from 16 to 3 by blocking the driving of the display by accumulating a count due to repeated opening and closing in hand mode or bag mode.

According to an embodiment, when ignoring the interrupt signal, the electronic device may control the display to turn on only a portion of the display to display a notification message (e.g., "Folding repetition detected" or "Folding repetition detected, only part of the screen has been turned on to conserve battery time. If you want to view the full screen, please touch below.") instead of a debounce time that forces the display off so as to reduce a risk of delaying a driving time (on time) of a screen of the display.

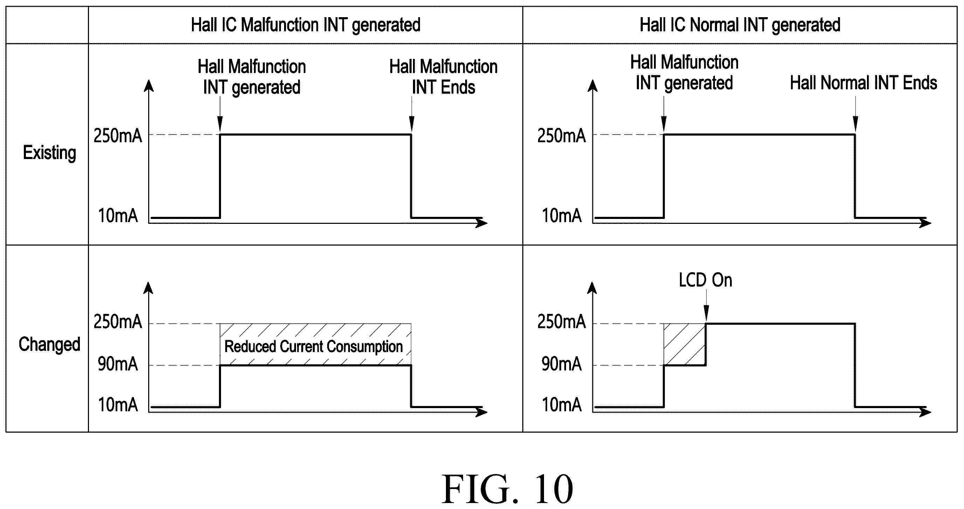

FIG. 10 is a view illustrating an effect of an operating method in an electronic device according to an embodiment.

Referring to FIG. 10, the electronic device (e.g., the electronic device 101 in FIGS. 1 and 2A to 2D) may recognize the reduction in current consumption by comparing the malfunction or the normal operation of the Hall IC in an existing or changed algorithm. The change algorithm consumes about 10mA in the sleep state, about 90 mA when the AP wakes up (e.g., LCD OFF) due to an interrupt signal generated by the Hall IC, and about 250 mA when the electronic device wakes up (e.g., AP and LCD ON). Accordingly, the changed algorithm may reduce the current consumption of about 160 mA (250-90 mA) compared to the current consumption of about 250mA of the existing algorithm, as the current consumption of about 90 mA is generated when the AP is woken up by an interrupt signal in the situation of Hall IC malfunction, and the current consumption of some regions may be reduced even when the Hall IC is operating normally.

According to an embodiment, an operating method of an electronic device (e.g., the electronic device 101 in FIGS. 1 and 2A to 2D) may include an operation of identifying folding angle information of a first housing and a second housing of the electronic device by using a motion sensor according to identifying an interrupt signal output by a Hall sensor (e.g., the first sensor 203 in FIG. 2B) of the electronic device based on a set threshold value.

According to an embodiment, the method may include an operation of changing the threshold value of the Hall sensor, based on the folding angle information.

According to an embodiment, the operation of changing the threshold value of the Hall sensor may include an operation of identifying a malfunction of the electronic device, based on motion information acquired using the motion sensor and an operation of changing the threshold value of the Hall sensor from a first threshold value to a second threshold value.

According to an embodiment, the motion information may include whether each of the first housing structure and the second housing structure moves and the amount of motion.

According to an embodiment, the motion sensor may include at least one 6-axis sensor. According to an embodiment, the first threshold value may be an open threshold angle set using a magnetic force value of one axis of the motion sensor, and the second threshold value may be an open threshold angle set using a magnetic force value of each of the three axes of the motion sensor.

According to an embodiment, the method may further include an operation of identifying a bag mode or a hand mode of the electronic device by using a grip sensor of the electronic device, an operation of acquiring a folding angle configured by the opening and closing of the electronic device by using the motion sensor, and an operation of identifying a malfunction caused by a hinge movement and changing a second threshold value of the Hall sensor, based on the folding angle being less than or equal to a first reference angle.

According to an embodiment, the method may include an operation of, in the bag mode, ignoring the interrupt signal for a specified time period based on identifying the folding angle being greater than the first reference angle and based on identifying the opening and closing repetition of a housing of the electronic device, and an operation of, in the bag mode, identifying a normal operation and switching the display of the electronic device to a driving state, based on identifying the folding angle being greater than the first reference angle and the absence of the opening and closing repetition of the housing of the electronic device. According to an embodiment, the opening and closing repetition may be identified in case that the interrupt signal has been generated a specified number of times or more during a specified time period.

According to an embodiment, the method may further include an operation of, in the hand mode, ignoring the interrupt signal for a specified time period based on identifying the folding angle being greater than the first reference angle and based on identifying the opening and closing repetition of a housing of the electronic device, and an operation of, in the hand mode, identifying a normal operation and switching the display of the electronic device to a driving state, based on identifying the folding angle being greater than the first reference angle and the absence of the opening and closing repetition of the housing of the electronic device.

According to an embodiment, the method may further include an operation of, in the hand mode, identifying the opening and closing repetition in case that the folding angle exceeds a second reference angle and the interrupt signal is generated a specified number of times or more during a specified first time period, and an operation of, in the hand mode, identifying the opening and closing repetition in case that the folding angle is less than or equal to the second reference angle and the interrupt signal is generated a specified number of times or more during a specified second time period.

According to an embodiment, the operation of changing the second threshold value of the Hall sensor may include an operation of changing the second threshold value to a second folding angle greater than a specified first folding angle.

According to an embodiment, the method may further include an operation of activating a partial area and deactivating a remaining area of the display of the electronic device, based on identifying the folding angle being greater than the first reference angle and based on identifying the opening and closing repetition of the first housing and the second housing and an operation of displaying a notification message on a partial area of the display.

According to an embodiment, the method may further include an operation of restoring the changed threshold value of the Hall sensor after performing an operation for driving the display.

According to an embodiment, a non-transitory computer-readable storage medium may store a program, wherein the program may include instructions, when executed by at least one processor of an electronic device, causing the electronic device to perform an operation of identifying generation of an interrupt signal output by a Hall sensor of the electronic device, an operation of identifying folding angle information of a first housing and a second housing of the electronic device by using a motion sensor of the electronic device, and an operation of changing a first threshold value of the Hall sensor, based on the folding angle information.

According to an embodiment, the electronic device may identify, by using a 6-axis sensor and a grip sensor in addition to the Hall IC, a malfunction caused by an external force and a malfunction caused by hinge movement that is impossible to be determined by the operation method of the Hall IC, and change the operation condition (e.g., the first threshold and the second threshold) of the Hall IC to match the malfunction, thereby preventing an increase in current consumption due to the driving of the display caused by the malfunction, resulting in a decrease in use time and heat generation. In addition, various effects directly or indirectly identified through the disclosure may be provided.

The embodiments disclosed herein are provided merely to easily describe technical details of the disclosure and to help the understanding of the disclosure, and are not intended to limit the scope of various embodiments of the present disclosure. Therefore, it should be construed that all modifications and changes or various other embodiments based on the technical idea of various embodiments of the disclosure fall within the scope of various embodiments of the disclosure.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., 'PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A foldable electronic device (101) comprising:
a first housing and a second housing which are foldable with respect to each other;
a magnetic substance disposed in at least one of the first housing and the second housing;
memory (130);
a Hall sensor (203) configured to detect a magnetic force value of the magnetic substance, which varies according to folding of the first housing and the second housing, and output an interrupt signal, based on a set threshold value;
a motion sensor; and
at least one processor (120) electrically connected to the Hall sensor, the motion sensor, and the memory,
wherein the memory stores instructions which, when executed by the at least one processor, cause the electronic device to:
according to identifying the interrupt signal, identify folding angle information of the first housing and the second housing by using the motion sensor; and
change the threshold value of the Hall sensor, based on the folding angle information.

2. The electronic device of claim 1, wherein the memory stores instructions which, when executed by the at least one processor, cause the electronic device to:
identify a malfunction of the electronic device, based on motion information acquired using the motion sensor; and
change the threshold value of the Hall sensor from a first threshold value to a second threshold value,
wherein the motion information comprises whether each of the first housing structure and the second housing structure is moved and an amount of motion thereof,
wherein the motion sensor comprises at least one 6-axis sensor,
wherein the first threshold value corresponds to an open threshold angle set using a magnetic force value of one axis of the motion sensor, and
wherein the second threshold value corresponds to an open threshold angle set using a magnetic force value of each of three axes of the motion sensor.

3. The electronic device of claim 1 or 2, wherein the memory stores instructions which, when executed by the at least one processor, cause the electronic device to:
identify a bag mode or a hand mode of the electronic device by using a grip sensor of the electronic device;
acquire a folding angle according to the opening and closing of the electronic device by using the motion sensor; and
identify a malfunction due to a hinge movement, and change a second threshold value of the Hall sensor, based on the folding angle being less than or equal to a first reference angle, and
wherein the second threshold value is changed to a second folding angle greater than a specified first folding angle.

4. The electronic device of one of claims 1 to 3, wherein the memory stores instructions which, when executed by the at least one processor, cause the electronic device to:
identify the opening and closing repetition, based on a number of occurrences of the interrupt signal during a specified time period being greater than or equal to a specified number of times;
in the bag mode, ignore the interrupt signal during a specified time period, based on the folding angle being greater than the first reference angle and identifying the opening and closing repetition of the first housing and the second housing; and
in the bag mode, identify a normal operation and switch a display of the electronic device to a driving state, based on the folding angle being greater than the first reference angle and identifying no opening and closing repetition.

5. The electronic device of one of claims 1 to 4, wherein the memory stores instructions which, when executed by the at least one processor, cause the electronic device to:
in the hand mode, ignore the interrupt signal during a specified time period, based on the folding angle being greater than the first reference angle and identifying the opening and closing repetition of the first housing and the second housing;
in the hand mode, identify a normal operation and switch the display of the electronic device to a driving state, based on the folding angle being greater than the first reference angle and identifying no opening and closing repetition;
in the hand mode, identify the opening and closing repetition, based on the folding angle being greater than a second reference angle and a number of occurrences of the interrupt signal during a specified first time period being greater than or equal to a specified number of times; and
in the hand mode, identify the opening and closing repetition, based on the folding angle being less than or equal to the second reference angle and a number of occurrences of the interrupt signal during a specified second time period being greater than or equal to a specified number of times.

6. The electronic device of one of claims 1 to 5, wherein the memory stores instructions which, when executed by the at least one processor, cause the electronic device to:
activate a partial area and deactivate a remaining area of the display of the electronic device, based on the folding angle being greater than the first reference angle and identifying the opening and closing repetition of the first housing and the second housing; and
control the display to display a notification message on the partial area of the display.

7. The electronic device of one of claims 1 to 6, wherein the memory stores instructions which, when executed by the at least one processor, cause the electronic device to restore the changed threshold value of the Hall sensor after performing an operation for driving the display.

8. An operating method of an electronic device (101), the method comprising:
identifying folding angle information of a first housing and a second housing of the electronic device by using a motion sensor according to identifying an interrupt signal output based on a set threshold value by a Hall sensor (203) of the electronic device; and
changing the threshold value of the Hall sensor, based on the folding angle information.

9. The method of claim 8, wherein the changing of the threshold value of the Hall sensor comprises:
identifying a malfunction of the electronic device, based on motion information acquired using the motion sensor; and
changing the threshold value of the Hall sensor from a first threshold value to a second threshold value,
wherein the changing of the second threshold value comprises changing the second threshold value to a second folding angle greater than a specified first folding angle,
wherein the motion information comprises whether each of the first housing structure and the second housing structure is moved and an amount of motion thereof,
wherein the motion sensor comprises at least one 6-axis sensor,
wherein the first threshold value corresponds to an open threshold angle set using a magnetic force value of one axis of the motion sensor, and
wherein the second threshold value corresponds to an open threshold angle set using a magnetic force value of each of three axes of the motion sensor.

10. The method of claim 8 or 9, further comprising:
identifying a bag mode or a hand mode of the electronic device by using a grip sensor of the electronic device;
acquiring a folding angle according to the opening and closing of the electronic device by using the motion sensor; and
identifying a malfunction due to a hinge movement and changing the second threshold value of the Hall sensor, based on the folding angle being less than or equal to a first reference angle.

11. The method of one of claims 8 to 10, further comprising:
in the bag mode, ignoring the interrupt signal during a specified time period, based on the folding angle being greater than the first reference angle and based on identifying an opening and closing repetition of the first housing and the first housing; and
in the bag mode, identifying a normal operation and switching a display of the electronic device to a driving state, based on the folding angle being greater than the first reference angle and based on identifying no opening and closing repetition, ,
wherein the opening and closing repetition is identified when a number of occurrences of the interrupt signal during a specified time period is greater than or equal to a specified number of times.

12. The method of one of claims 8 to 11, further comprising:
in the hand mode, ignoring the interrupt signal during a specified time period, based on the folding angle being greater than the first reference angle and based on identifying the opening and closing repetition of the first housing and the second housing;
in the hand mode, identifying a normal operation and switching the display of the electronic device to a driving state, based on the folding angle being greater than the first reference angle and based on identifying no opening and closing repetition,;
in the hand mode, identifying the opening and closing repetition, based on the folding angle being greater than a second reference angle and a number of occurrences of the interrupt signal during a specified first time period being greater than or equal to a specified number of times; and
in the hand mode, identifying the opening and closing repetition, based on the folding angle being less than or equal to the second reference angle and a number of occurrences of the interrupt signal during a specified first time period being greater than or equal to a specified number of times.

13. The method of one of claims 8 to 12, further comprising:
activating a partial area and deactivating a remaining area of the display of the electronic device, based on the folding angle being greater than the first reference angle and based on identifying the opening and closing repetition of the first housing and the second housing; and
displaying a notification message on the partial area of the display.

14. The method of one of claims 8 to 13, further comprising restoring the changed threshold value of the Hall sensor after performing an operation for driving the display.

15. A non-transitory computer-readable storage medium storing a program, wherein the program comprises instructions executable to, when executed by at least one processor of an electronic device, cause the electronic device to perform:
identifying folding angle information of a first housing and a second housing of the electronic device by using a motion sensor of the electronic device according to identifying occurrences of an interrupt signal output by a Hall sensor of the electronic device; and
changing a first threshold value of the Hall sensor, based on the folding angle information.
